Europäisches Patentamt

(19) **European Patent Office**

**Office européen des brevets**

(11) Veröffentlichungsnummer: **0 260 376**
**A1**

(12) **EUROPÄISCHE PATENTANMELDUNG**

(21) Anmeldenummer: **87105586.9**

(51) Int. Cl.⁴: **H 01 L 27/14**

(22) Anmeldetag: **15.04.87**

(30) Priorität: **01.09.86 DE 3629685**

(43) Veröffentlichungstag der Anmeldung: **23.03.88**
**Patentblatt 88/12**

(84) Benannte Vertragsstaaten: **DE FR GB IT**

(71) Anmelder: **Licentia Patent-Verwaltungs-GmbH,**
**Theodor-Stern-Kai 1, D-6000 Frankfurt/Main 70 (DE)**

(72) Erfinder: **Dämbkes, Heinrich, Dr.-Ing., Stäudlenweg 29,**
**D-7900 Ulm (DE)**
Erfinder: **König, Ulf, Dr.-Ing., Scultetusweg 2, D-7900 Ulm**
**(DE)**
Erfinder: **Haspeklo, Horst, Dr.rer.nat., Lindenweg 12,**
**D-7915 Elchingen (DE)**

(74) Vertreter: **Schulze, Harald Rudolf, Dipl.-Ing. et al,**
**Licentia Patent-Verwaltungs-GmbH**
**Theodor-Stern-Kai 1, D-6000 Frankfurt/Main 70 (DE)**

(54) **Photoempfänger.**

(57) Die Erfindung betrifft einen monolithisch integrierten Photoempfänger aus zumindest einer PIN-Diode und mindestens einem HEMT. Der Photoempfänger ist für einen in der Lichtleitfasertechnik netzbaren Wellenlängenbereich von 0,8 bis 1,55 µm geeignet. Die Steuerung des HEMT und der PIN-Diode erfolgt über p-leitende Gebiete.

EP 0 260 376 A1

Licentia Patent-Verwaltungs-GmbH     PTL-UL/Dr.Bk/rß
Theodor-Stern-Kai 1                   UL 86/69b

D-6000 Frankfurt 70                   Aktz.:
                                      P 36 29 685.6

Beschreibung

"Photoempfänger"

Die Erfindung betrifft einen monolithisch integrierten Photoempfänger nach dem Oberbegriff des Patentanspruchs 1.

Photoempfänger gemäß der Erfindung sind für Meß- oder Nachrichtenübertragungssysteme geeignet. Vorbekannte Lösungen von monolithisch integrierten optoelektronischen Empfängerschaltungen sind beispielsweise eine Kombination aus einer PIN-Diode und einem JFET(Junction Field Effect Transistor) auf InGaAs Basis(Lit.: R.E.Nahory, R.F.Leheny, Proc.Soc.Photo-Optical Instrum. Eng. 272(1981), S.32-35) oder eine Kombination aus einer PIN-Diode und einem Heterobipolartransistor aus InP/InGaAsP-Verbindungen. Diese optoelektronischen Empfängerschaltungen haben jedoch den Nachteil, daß sie eine geringe Schaltgeschwindigkeit und hohe Rauschzahlen besitzen.

Ein monolithisch integrierter Photoempfänger bestehend aus PIN-Diode und Feldeffekttransistor, beispielsweise ein HEMT, wird in der europäischen Patentanmeldung EP-A 0 133 709 beschrieben. Die Steuerung des HEMT erfolgt über ein mehrschichtiges, p-leitendes Gate. PIN-Diode und HEMT sind nicht planar angeordnet.

Der Erfindung liegt daher die Aufgabe zugrunde, einen schnellschaltenden monolithisch integrierten Photoempfänger anzugeben, der insbesondere für einen für die Lichtleitfasertechnik nützlichen Wellenlängenbereich $\lambda$ von vorzugsweise $0{,}8 \leq \lambda \leq 1{,}55\mu m$ geeignet ist und der bei einer technisch zuverlässigen und kostengünstigen Herstellung eine möglichst hohe Packungsdichte von elektronischen Bauelementen ermöglicht.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Der monolithisch integrierte Photoempfänger gemäß der Erfindung hat den Vorteil, daß ein schnellschaltender Feldeffekttransistor, dessen Grenzfrequenz im GHz-Bereich liegt, der einen hochohmigen Eingangswiderstand hat und sehr rauscharm ist, mit einem optischen Detektor mit hohem Quantenwirkungsgrad und geringem Rauschen kombiniert werden kann.

...

Ein weiterer Vorteil der Erfindung besteht darin, daß die Steuerung des Gates als auch der p-Kontakte der PIN-Diode über, in den Halbleiterschichten erzeugte, p-leitende Gebiete erfolgt. Dadurch wird ein planarer Aufbau des Photoempfängers erzielt, bei dem alle elektrischen Kontakte auf einer Ebene liegen. Eine geeignete Verbindung der elektrischen Kontakte, z.B. über metallische Leiterbahnen, ist somit technisch einfach und zuverlässig durchführbar.

Die Erfindung wird im folgenden anhand von Ausführungsbeispielen näher erläutert unter Bezugnahme auf eine schematische Zeichnung.

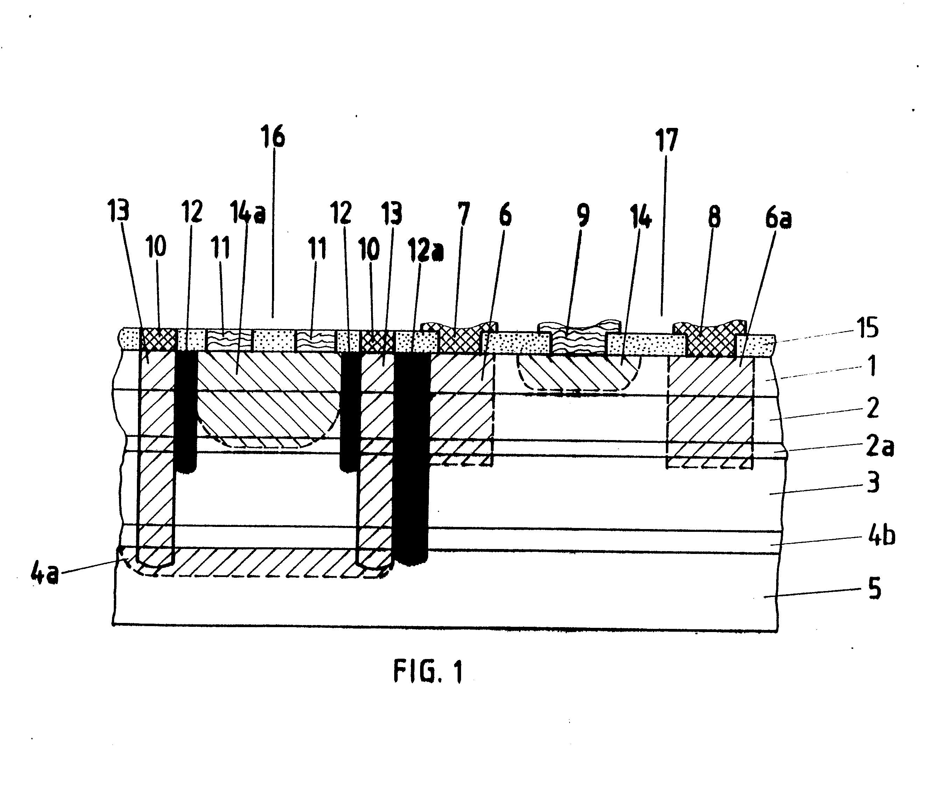

Fig. 1    zeigt einen monolithisch integrierten Photoempfänger bestehend aus einer PIN-Diode 16 und einem HEMT (High Electron Mobilitiy Transistor) 17.

Gemäß Fig. 1 ist in das Substrat 5, das z.B. aus halblisolierenden InP besteht, im Bereich der PIN-Diode 16 eine n-implantierte Zone 4a mit einer Ladungsträgerkonzentration von $10^{17}$-$10^{18}$ cm$^{-3}$ und einer Tiefe von ungefähr 0,5μm eingebracht. Auf das Substrat 5 kann eine undotierte Pufferschicht 4b, z.B. aus InP, mit einer Schichtdicke von ungefähr 0,2 bis 1μm aufgewachsen werden. Auf die Pufferschicht 4b oder direkt auf das Substrat 5 ist eine Heterostruktur-Halbleiterschichtenfolge aus

- einer n$^{--}$-dotierten Halbleiterschicht 3 aus InGaAs oder InGaAsP mit einer Ladungsträgerkonzentration von

. . .

$10^{14}$-$10^{16}$cm$^{-3}$ und einer Schichtdicke von 1,5 bis 2,5µm,

- einer undotierten Halbleiterschicht 2a aus InP oder InGaAsP oder InAlAs mit eine Schichtdicke von ungefähr 5nm,

- einer n$^+$-dotierten Halbleiterschicht 2 aus InP oder InGaAsP oder InAlAs mit einer Ladungsträgerkonzentration von $10^{17}$-5.$10^{18}$ cm$^3$ und einer Schichtdicke von 10 bis 50nm,

- einer undotierten oder n$^-$-dotierten abschließenden Halbleiterschicht 1 aus InGaAs oder InGaAsP mit einer Schichtdicke von ungefähr 300nm und einer Ladungsträgerkonzentation von weniger als $10^{17}$cm$^{-3}$

aufgewachsen.

Besteht das Substrat 5 z.B. aus halbisolierendem GaAs, ist die nachfolgend aufgewachsene Halbleiterschichtenfolge vorzugsweise aus einer undotierten Halbleiterschicht 4b aus GaAs, einer n$^{--}$-dotierten Halbleiterschicht 3 aus GaAs oder In$_x$Ga$_{1-x}$As (x$<$0,1), einer undotierten Halbleiterschicht 2a aus GaAs oder GaAlAs, einer n$^+$-dotierten Halbleiterschicht 2 aus GaAlAs und einer n$^-$-dotierten Halbleiterschicht 1 aus GaAs aufgebaut. Die Schichtdicken und Dotierkonzentrationen sind entsprechend dem oben beschriebenen Ausführungsbeispiel gewählt.

Alternativ zu den oben beschriebenen Heterostruktur-Halbleiterschichtenfolgen ist beispielsweise eine Halbleiterschichtenfolge herstellbar,

- die anstatt der undotierten Pufferschicht 4b ein undotiertes InP/InGaAs-Übergitter besitzt und/oder in die anstatt der $n^+$-dotierten Halbleiterschicht 2 und der undotierten Halbleiterschicht 2a ein Übergitter aus gitterangepaßten Materialien wie InAlAs/-InGaAs oder InP/InGaAsP oder aus gitterfehlangepaßten Materialien, deren Dicken jeweils unterhalb einer kristischen Schichtdicke liegen, wie z.B. GaP, GaAs oder InAlAs, eingebaut ist.

An der Heterogrenzfläche der undotierten Halbleiterschicht 2a und der $n^{--}$-dotierten Halbleiterschicht 3 entsteht ein zweidimensionales Elektronengas. Dabei werden die Elektronen im wesentlichen in der $n^{--}$-dotierten Halbleiterschicht 3 geführt.

Nach dem Aufwachsen der Heterostruktur werden senkrecht zu den Halbleiterschichten durch Ionenimplantation oder Diffusion die n-leitenden Gebiete 6, 6a und 13 sowie die p-leitenden Gebiete 14 und 14a erzeugt. Die n-leitenden Gebiete 6 und 6a reichen von der abschließenden, $n^-$-dotierten Halbleiterschicht 1 bis in die $n^{--}$-dotierte Halbleiterschicht 3 der Heterostruktur. Sie bilden die Source- und Drain-Bereiche des HEMT 17, auf denen sperrfreie metallische Kontakte, z.B. aus einer Au/Ge-Legierung, aufgebracht sind. Die Steuerelektrode 9 des HEMT 17, der sog. Gate-Anschluß, ist ein metallischer Kontakt, der das p-leitende Gebiet 14 kontaktiert.

Senkrecht zu der Halbleiterschichtenfolge verläuft ein n-leitendes Gebiet 13, das die zweite Elektrode 10 der PIN-Diode 16 mit der n-implantierten Zone 4a verbindet. Die erste Elektrode 11 der PIN-Diode 16 ist mit einem

...

p-leitenden Gebiet 14a kontaktiert, das senkrecht zu den Halbleiterschichten 1, 2 verläuft und bis in die undotierte Halbleiterschicht 2a reicht. Die Elektroden 10, 11 der PIN-Diode 16 sind beispielsweise ringförmig ausgebildet und aus einer Au/Ge-Legierung hergestellt.

Als Dotierstoffe für die p-Dotierung werden besipielsweise Be, Mg oder Zn und für die n-Dotierung Si, S oder Sn verwendet. Die durch Ionenimplantation entstandenen Schäden im Kristall werden durch einen anschließneden Temperprozeß ausgeheilt.

Ein erstes Isolationsgebiet 12, das senkrecht zu den Halbleiterschichten 1, 2 verläuft und bis in die $n^{--}$-dotierte Halbleiterschicht 3 reicht, trennt die Elektroden 10, 11 der PIN-Diode 16. Ein zweites Isolationsgebiet 12a, das senkrecht zur Halbleiterschichtenfolge verläuft und bis in das Substrat 5 reicht, grenzt PIN-Diode 16 und HEMT 17 voneinander ab. Die Isolationsgebiete 12, 12a werden entweder durch Ionenimplantation, z.B. mit Fe, oder durch geeignete Ätz- und anschließende Auffülltechniken, z.B. mit Polyimid, hergestellt.

Die Oberfläche der abschließenden Halbleiterschicht 1 der Heterostruktur ist durch eine isolierende Schicht 15 aus z.B. $SiO_2$ geschützt, in der sich Fenster zum Anbringen der elektrischen Kontakte 7, 8, 9, 10, 11 befinden.

Die elektrischen Kontakte von PIN-Diode 16 und HEMT 17 sind z.B. über metallische Leiterbahnen in geeigneter

...

Weise miteinander verbunden.


Vorteilhafterweise wird die Kompatibilität von PIN-Diode 16 und HEMT 17 zur Herstellung eines erfindungsgemäßen Photoempfängers dadurch erreicht, daß die $n^{--}$-dotierte Halbleiterschicht 3

- als Absorptionsschicht der PIN-Diode 16 ausgebildet ist,

- eine geeignete Schichtdicke von ungefähr 2μm besitzt, so daß die Photonen vollständig absorbiert werden,

- einen geringeren Bandabstand als die darauf aufgewachsenen Halbleiterschichten 2, 2a besitzt, damit sich im HEMT 17 in der $n^{--}$-dotierten Halbleiterschicht 3 ein Potentialtopf ausbildet, in dem sich die Elektronen quasi-frei bewegen können.


Die Steuerelektrode 9 des HEMT 17, die auf dem p-leitenden Gebiet 14 aufgebracht ist, bildet ein sog. p-Gate. Dieses p-Gate hat den Vorteil, daß die Sperreigenschaften der Steuererelektrode 9 verbessert werden, da das p-leitende Gebiet 14 und die $n^{+}$-dotierte Halbleiterschicht 2 einen p-n-Übergang bilden. An der Grenzfläche des p-leitenden Gebietes 14 enststeht eine Raumladungszone. Zur Herstellung des erfindungsgemäßen Photoempfängers können deshalb Halbleitermaterialien mit geringem Bandabstand verwendet werden, die sich für Schottky-Kontakte sonst nur schlecht eignen.


Außerdem ist durch die an der Grenzfläche des p-leitenden Gebietes 14 ausgebildete Raumladungszone ein Durchgriff

...

durch die extrem dünnen Halbleiterschichten 2, 2a zur $n^{--}$-dotierten Halbleiterschicht 3 möglich. Im Falle der PIN-Diode 16 werden durch geeignete Vorspannung mit Hilfe der entstandenen Raumladungszone die freien Ladungsträger aus der $n^{--}$-dotierten Halbleiterschicht 3 entfernt.

Monolithisch integrierte Photoempfänger gemäß der Erfindung, lassen sich mit Hilfe der Molekularstrahl-Epitaxie oder der chemischen Gasphasen-Epitaxie aus metallorganischen Verbindungen herstellen.

Die Erfindung ist nicht auf die beschriebenen Ausführungsbeispiele beschränkt, sondern sinngemäß auf weitere Materialkombinationen anwendbar.

Licentia Patent-Verwaltungs-GmbH     PTL-UL/Dr.Bk/rß
Theodor-Stern-Kai 1                  UL 86/69b
D-6000 Frankfurt 70                  Aktz.:
                                     P 36 29 685.6

<u>Patentansprüche</u>

1. Monolithisch integrierter Photoempfänger, bestehend
aus einem Substrat, auf dem eine Halbleiterschichtenfolge
aufgebracht ist, die zumindest eine PIN-Diode, sowie
mindestens einen Feldeffekttransistor, insbesondere einen
HEMT, enthält, <u>dadurch gekennzeichnet,</u>
-     daß PIN-Diode (16) und HEMT (17) aus der gleichen
      Heterostruktur-Halbleiterschichtenfolge hergestellt
      sind,
-     daß die abschließende Halbleiterschicht (1) der
      Heterostruktur als undotierte oder $n^-$-dotierte Deckschicht ausgebildet ist,
-     daß die Steuerelektrode (9) des HEMT (17) auf einem
      in die abschließende Halbleiterschicht (1) der Heterostruktur p-leitendes Gebiet   (14) aufgebracht ist, und
-     daß die erste Elektrode (11) der PIN-Diode (16) ein

...

p-leitendes Gebiet (14a) kontaktiert, das senkrecht
zu den Halbleiterschichten (1, 2) verläuft und bis in
die undotierte Halbleiterschicht (2a) reicht.

2. Monolithisch integrierter Photoempfänger nach Anspruch,
1 dadurch gekennzeichnet, daß die Halbleitermaterialien so
gewählt sind, daß der Wellenlängenbereich $\lambda$ des Photoempfängers zwischen $0,8 \leq \lambda \leq 1,55 \mu m$ liegt.

3. Monolithisch integrierter Photoempfänger nach einem
der vorhergehenden Ansprüche, dadurch gekennzeichnet, daß
die PIN-Diode (16) eine in das Substrat (5) n-implantierte
Zone (4a) enthält.

4. Monolithisch integrierter Photoempfänger nach einem
der vorhergehenden Ansprüche, dadurch gekennzeichnet, daß
auf dem Substrat (5) eine undotierte Pufferschicht (4b)
aufgebracht ist.

5. Monolithisch integrierter Photoempfänger nach einem
der Ansprüche 1 bis 3, dadurch gekennzeichnet, daß auf dem
Substrat (5) eine Pufferschicht (4b) aufgebracht ist, die
als undotiertes Übergitter ausgebildet ist.

6. Monolithisch integrierter Photoempfänger nach einem
der vorhergehenden Ansprüche, dadurch gekennzeichnet, daß
auf das Substrat (5) oder auf die Pufferschicht (4b) oder
die Übergitterstruktur eine Heterostruktur-Halbleiterschichtenfolge aus einer $n^{--}$-dotierten Halbleiterschicht
(3), einer undotierten Halbleiterschicht (2a), einer

...

$n^+$-dotierten Halbleiterschicht (2) und einer undotierten oder $n^-$-dotierten, abschließenden Halbleiterschicht (1) epitaktisch aufgewachsen ist.

7. Monolithisch integrierter Photoempfänger nach einem der vorhergehenden Ansprüche, dadurch gekennzeichnet, daß die $n^+$-dotierte Halbleiterschicht (2), und die undotierte Halbleiterschicht (2a) als Übergitter ausgebildet sind.

8. Monolithisch integrierter Photoempfänger nach einem der vorhergehenden Ansprüche, dadurch gekennzeichnet, daß PIN-Diode (16) und HEMT (17) planar angeordnet sind.

9. Monolithisch integrierter Photoempfänger nach einem der vorhergehenden Ansprüche, dadurch gekennzeichnet, daß Source- (7) und Drain-Anschluß (8) des HEMT (17) die n-leitenden Gebiete (6, 6a) kontaktieren, die senkrecht zu den Halbleiterschichten (1, 2, 2a) verlaufen und bis in die $n^{--}$-dotierte Halbleiterschicht (3) reichen.

10. Monolithisch integrierter Photoempfänger nach einem der vorhergehenden Ansprüche, dadurch gekennzeichnet, daß die zweite Elektrode (10) der PIN-Diode (16) über ein n-leitendes Gebiet (13) das senkrecht zur Halbleiterschichtenfolge verläuft, die n-implantierte Zone (4a) kontaktiert.

11. Monolithisch integrierter Photoempfänger nach einem der vorhergehenden Ansprüche, dadurch gekennzeichnet, daß das p-leitende Gebiet (14a) und das n-leitende Gebiet (13)

...

der PIN-Diode (16) durch ein erstes Isolationsgebiet (12), das senkrecht zu den Halbleiterschichten (1, 2, 2a) verläuft und bis in die n⁻⁻-dotierte Halbleiterschicht (3) reicht, getrennt sind.

12. Monolithisch integrierter Photoempfänger nach einem der vorhergehenden Ansprüche, dadurch gekennzeichnet, daß PIN-Diode (16) und HEMT (17) durch ein zweites Isolationsgebiet (12a) abgegrenzt sind, das senkrecht zur Halbleiterschichtenfolge verläuft und bis ins Substrat (5) reicht.

0 260 376

UL 86/698

FIG. 1

Europäisches
Patentamt

EUROPÄISCHER RECHERCHENBERICHT

0 260 376

EP 87 10 5586

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y,D | EP-A-0 133 709 (ITT)<br>* Figur 1; Seite 2, Zeilen 14-22,31-37; Seite 4, Zeilen 7-10,12-15 *<br>--- | 1,3,4,6 | H 01 L 27/14 |
| Y | WO-A-8 604 735 (ATT)<br>* Figur 1; Seite 5, Zeilen 9-13 *<br>--- | 1,3,4,6 | |
| Y | PATENT ABSTRACTS OF JAPAN, Band 11, Nr. 20 (E-472) [2467], 20. Januar 1987; & JP-A-61 191065 (MATSUSHITA ELECTRIC IND CO LTD) 25-08-1986<br>* Figur; Zusammenfassung * | 1,3,4,6 | |
| A | IDEM<br>--- | 8 | |
| A | IEEE 1983 GaAs IC SYMPOSIUM, Technical Digest, Phoenix, 25.-27. Oktober 1983, Seiten 52-55, IEEE, New York, US; O. WADA et al.: "Monolithic laser/FET and PIN/FET as optoelectronic integrated circuits (OEIC's) by AlGaAs/GaAs heterostructures"<br>* Seite 54, Zeilen 1-4 *<br>--- | 2 | RECHERCHIERTE SACHGEBIETE (Int. Cl.4)<br><br>H 01 L |
| A | IEEE JOURNAL OF QUANTUM ELECTRONICS, Band QE-18, Nr. 6, Juni 1982, Seiten 992-995, IEEE, New York, US; J.C. CAMPBELL et al.: "Optical AND gate"<br>* Figur 4 *<br>--- | 2 | |
| A | APPLIED PHYSICS LETTERS, Band 44, Nr. 4, 15. Februar 1984, Seiten 435-437, American Institute of Physics, New York, US; W.T. MASSELINK et al.: "Improved GaAs/AlGaAs single quantum wells through the use of thin superlattice buffers"<br>* Zusammenfassung; Figuren 1C,2 *<br>---                         -/- | 5 | |

Der vorliegende Recherchenbericht wurde für alle Patentansprüche erstellt

| Recherchenort | Abschlußdatum der Recherche | Prüfer |
|---|---|---|
| DEN HAAG | 08-12-1987 | JUHL A. |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 005 059 (WESTERN ELECTRIC CO.) * Figur 6; Seite 11, Zeilen 25-37 * --- | 7 | |
| A | INTERNATIONAL ELECTRON DEVICES MEETING, Technical Digest, December 1983, Seiten 689-691, Washington, D.C., US; C. DUBON et al.: "Double heterojunction GaAs-GaAlAs bipolar transistors grown by MOCVD for emitter coupled logic circuits" * Figur 1; Seite 690, Zeilen 29-35 * --- | 9,10 | |
| A | EP-A-0 064 829 (FUJITSU) * Figur 3; Seite 12, Zeilen 1-14 * ----- | 11,12 | |

RECHERCHIERTE SACHGEBIETE (Int. Cl.4)

Der vorliegende Recherchenbericht wurde für alle Patentansprüche erstellt

| Recherchenort | Abschlußdatum der Recherche | Prüfer |
|---|---|---|
| DEN HAAG | 08-12-1987 | JUHL A. |

EPO FORM 1503 03.82 (P0403)